(19) Europäisches Patentamt / European Patent Office / Office européen des brevets

(11) **EP 4 053 632 A1**

(12) **EUROPEAN PATENT APPLICATION**

(43) Date of publication:
**07.09.2022 Bulletin 2022/36**

(21) Application number: **22159540.8**

(22) Date of filing: **01.03.2022**

(51) International Patent Classification (IPC):
**G03F 1/24** *(2012.01)*  **G03F 1/26** *(2012.01)*
**G03F 1/54** *(2012.01)*  **G03F 1/58** *(2012.01)*

(52) Cooperative Patent Classification (CPC):
**G03F 1/24; G03F 1/26; G03F 1/54; G03F 1/58**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **03.03.2021 JP 2021033133**
**18.01.2022 JP 2022005411**

(71) Applicant: **Shin-Etsu Chemical Co., Ltd.**
**Tokyo (JP)**

(72) Inventors:
• **TERASAWA, Tsuneo**
  **Niigata-ken (JP)**
• **KANEKO, Hideo**
  **Niigata-ken (JP)**
• **MIMURA, Shohei**
  **Niigata-ken (JP)**

(74) Representative: **Mewburn Ellis LLP**
**Aurora Building**
**Counterslip**
**Bristol BS1 6BX (GB)**

(54) **REFLECTIVE MASK BLANK, AND METHOD FOR MANUFACTURING THEREOF**

(57)    Metal and metalloid elements for an absorber film of a reflective mask blank are selected from first, second and third elements included in first, second and third regions, respectively, that are defined by a refractive index n and an extinction coefficient k of a simple substance of each of the metal and metalloid elements, and the absorber film is formed so as to have a reflectance ratio of 0.05 to 0.25, and a phase shift of 180 to 260° by the selected metal and metalloid elements.

FIG.1A

EP 4 053 632 A1

## Description

TECHNICAL FIELD

The present invention relates to a reflective mask blank for manufacturing a reflective mask used for manufacturing a semiconductor device, particularly, a reflective mask blank capable of imparting high ability of pattern transfer in a reflective mask obtained from the reflective mask blank, and a method for manufacturing thereof.

BACKGROUND

In a manufacturing process of a semiconductor device, a photolithography technique in which a circuit pattern formed on a transfer mask is transferred onto a semiconductor substrate (semiconductor wafer) through a reduction projection optical system with irradiating exposure light to the transfer mask is repeatedly used. Conventionally, a mainstream wavelength of the exposure light is 193 nm by argon fluoride (ArF) excimer laser light. A pattern with dimensions smaller than exposure wavelength has finally been formed by adopting a process called multi-patterning in which exposure processes and processing processes are combined multiple times.

However, since it is necessary to form a further fine pattern under continuous miniaturization of device patterns, EUV lithography technique using, as exposure light, extreme ultraviolet (hereinafter referred to "EUV") light having a wavelength shorter than ArF excimer laser light is proposed. EUV light is light having a wavelength of about 0.2 to 100 nm, more specifically, light having a wavelength of around 13.5 nm. This EUV light has a very low transparency to a substance. Therefore, a non-conventional reflective exposure optical system and reflective mask are used. The reflective mask has a multilayer reflection film which reflects EUV light, and a protection film that are formed on a substrate, and a patterned absorber film that is formed thereon and absorbs EUV light. Here, a material (also including a material in which a resist layer is formed) before patterning the absorber film is called a reflective mask blank, and is used as a material for the reflective mask. Hereinafter, a reflective mask blank that reflects EUV light is also referred to as an EUV mask blank.

In a general reflective mask that reflects EUV light, EUV light that incidents on the reflective mask mounted on an exposure tool (a pattern transfer tool) is reflected with a predetermined reflectance at the portion where the absorber film is not formed. At the portion where the absorber film is formed, the light is absorbed by the absorber film with reducing the reflectance, and is scarcely reflected. As a result, an optical image of the pattern formed on the reflective mask is transferred as a projection image onto a semiconductor substrate. At present, when an absorber film containing Ta (tantalum) as a main component is used, the reflectance is about 1% at a film thickness of 70 nm. On the other hand, the multilayer reflection film has effectively a reflectance of is 65 to 67%. Thus, in the reflective mask, the ratio (reflectance ratio) of the reflectance at the portion where the absorber film (absorber pattern) is formed to the reflectance at the portion where the absorber film is not formed (the portion where the multilayer reflection film or the protection film thereof is exposed) is approximately 1.5 to 2%.

On the other hand, when the phase difference (phase shift) between light slightly reflected from the portion where the absorber film is formed and light reflected from the portion where the absorber film is not formed is set, for example, to 180°, high contrast can be obtained in the optical image of the pattern formed in the reflective mask by utilizing the phase shift. In particular, in a fine dimensional range, when the reflectance ratio is 1.5 to 2%, the contrast of a projected image of the pattern transferred on the semiconductor substrate is insufficient, therefore, it is necessary to utilize the phase shift. Prior arts relating to a reflective mask blank for manufacturing an EUV mask in consideration of such a phase shift are disclosed in, for example, JP-A 2006-228766 (Patent Document 1) and JP-A 2011-29334 (Patent Document 2).

Citation List

Patent Document 1: JP-A 2006-228766
Patent Document 2: JP-A 2011-29334

SUMMARY OF THE INVENTION

The reflectance ratio (1.5 to 2%) of the absorber film containing Ta (tantalum) as a main component is one digit higher than that of a light-shielding film in a transmissive photomask using ArF excimer laser light. However, when the absorber film has the phase shift, even if the absorption performance is slightly low, the absorber film has an advantage in that contrast of the optical image (projected image) of the pattern can be obtained by the phase shift function. On the other hand, in a finer dimensional range, three-dimensional effect that depends to a thickness of the absorber film, so-called shadowing effect, remarkably appears. In order to reduce this effect, the absorber film must be thin. However, when the absorber film is thin, the phase shift becomes smaller with increasing the reflectance ratio, and the phase shift function is weakened. Therefore, a thin absorber film has a problem that the contrast of the optical image (projected image) of the pattern cannot be sufficiently obtained.

Further, the reflectance ratio and the phase shift required for the reflective mask using the phase shift function vary and depend to shape and density of the transfer pattern, lighting conditions for to the pattern, and other parameters. These parameters can be obtained by optical simulation, and values of optical constants such as a refractive index n and an extinction coefficient k required for the absorber film can be obtained by setting the thickness of the absorber film. However, a material that can satisfy values of optical constants required for the absorber film does not exist practically in a single metal or metalloid material, thus it is difficult to realize sufficient values by the single metal or metalloid material. In addition, neither JP-A 2006-228766 (Patent Document 1) nor JP-A 2011-29334 (Patent Document 2) considers that the required reflectance ratio and phase shift in the reflective mask are determined in accordance with shape and density of the pattern to be transferred, lighting conditions for the pattern, and other parameters.

The present invention has been made to solve the above problems, and an object of the present invention is to provide a reflective mask blank including a thin absorber film in which a reflection ratio and a phase shift required in a reflective mask utilizing phase shift function are ensured, and a method that can effectively manufacture such a reflective mask blank utilizing the phase shift function.

The inventers found that an absorber film composed of a material containing at least three kinds of elements, as metal and metalloid elements, that are selected from two or three elemental groups among a first elemental group, a second elemental group and a third elemental group specified by a refractive index n and an extinction coefficient k, in particular, in the case that each of the selected two or three elemental groups includes at least one of the at least three kinds of elements, can effectively provide a reflective mask blank including a thin absorber film that is ensured a reflectance ratio and a phase shift necessary for utilizing phase shift function.

Further, inventors found that the absorber film is formed by selecting metal and metalloid elements from two or three regions among a first region, a second region and a third region that are specified by a refractive index n and an extinction coefficient k, in particular, in the case that each of the selected two or three regions includes at least one of the elements, and determining contents of these elements so that a reflectance ratio and a phase shift correspond to an intended reflectance ratio and an intended phase shift. According to this way, a valid material for the absorber film that can provide a required reflectance ratio and a phase shift in the reflective mask can be effectively selected, based on optical constants such as a refractive index n and an extinction coefficient k, in accordance with shape and density of a pattern to be transferred, or lighting conditions for the pattern. Further, a reflective mask blank can be manufactured by forming a thin absorber film that is ensured a necessary reflectance ratio and a necessary phase shift by the selected material.

In one aspect, the invention provides a reflective mask blank in which a multilayer reflection film that reflects EUV light, a protection film, and an absorber film that absorbs a part of incident EUV light and reflects the remainder of the EUV light are formed in this order on one main surface of a substrate, wherein

with respect to EUV light, a reflectance ratio ($R_A/R_B$) that is a ratio of a reflectance $R_A$ (%) of the absorber film to a reflectance $R_B$ (%) of the multilayer reflection film and the protection film is 0.05 to 0.25, the absorber film has phase shift function that shifts a phase of the reflected light from the absorber film in a range of 180 to 260° to a phase of the reflected light from the multilayer reflection film and the protection film, the absorber film is composed of a material containing at least three kinds of metal or metalloid elements, the at least three kinds of metal or metalloid elements are selected from two or three elemental groups selected from the group consisting of a first elemental group, a second elemental group and a third elemental group, each of the selected two or three elemental groups includes at least one of the at least three kinds of metal or metalloid elements, each of the metal and metalloid elements included in each of the first, second and third elemental groups has a refractive index n and an extinction coefficient k of a simple substance of metal or metalloid, each of the metal or metalloid elements included in the first elemental group satisfies the following expression (1):

$$k \leq 0.01 \qquad (1),$$

each of the metal or metalloid elements included in the second elemental group is a metal or metalloid element not included in the first elemental group, and satisfies the following expression (2):

$$n + 2k \geq 0.99 \qquad (2), \text{ and}$$

each of the metal or metalloid elements included in the third elemental group is a metal or metalloid element not included in both of the first and second elemental groups, and satisfies the following expression (3):

$$n \leq 0.89 \qquad (3).$$

Preferably, the metal or metalloid elements included in the first elemental group are Mo, Nb, Zr, Si and Y,

the metal or metalloid elements included in the second elemental group are W, Au, Ir, V, Pt, Cr, Ta, Hf, Co, Ni, Sn and Te, and the metal or metalloid elements included in the third elemental group are Ru, Rh, and Pd.

Preferably, the metal or metalloid elements included in the first elemental group are Mo,

the metal or metalloid elements included in the second elemental group are W, and
the metal or metalloid elements included in the third elemental group are Ru.

Preferably, each content of the three kinds of elements selected from the elemental groups is not less than 5 at%.

Preferably, in the reflective mask blank, a conductive film is formed on the other main surface of the substrate.

Preferably, the absorber film has phase shift function that shifts a phase of the reflected light from the absorber film in a range of 180 to 240° to a phase of the reflected light from the multilayer reflection film and the protection film.

In another aspect, the invention provides a method for manufacturing a reflective mask blank in which a multilayer reflection film that reflects EUV light, a protection film, and an absorber film that absorbs a part of incident EUV light and reflects the remainder of the EUV light are formed in this order on one main surface of a substrate, wherein

with respect to EUV light, a reflectance ratio ($R_A/R_B$) that is a ratio of a reflectance $R_A$ (%) of the absorber film to a reflectance $R_B$ (%) of the multilayer reflection film and the protection film is 0.05 to 0.25,
the absorber film has phase shift function that shifts a phase of the reflected light from the absorber film in a range of 180 to 260° to a phase of the reflected light from the multilayer reflection film and the protection film, and
the absorber film contains metal or metalloid elements, wherein
the method includes steps of:

(A) classifying each of the metal or metalloid elements to anyone of a first element included in a first region, a second element included in a second region, and a third element included in a third region,

each of the metal and metalloid elements having a refractive index n and an extinction coefficient k of a simple substance of metal or metalloid,
the first element included in the first region satisfying the following expression (1):

$$k \leq 0.01 \qquad (1),$$

the second element included in the second region being a metal or metalloid element not included in the first region, and satisfying the following expression (2):

$$n + 2k \geq 0.99 \qquad (2), \text{ and}$$

the third element included in the third region being a metal or metalloid element not included in both of the first and second regions, and satisfying the following expression (3):

$$n \leq 0.89 \qquad (3);$$

(B) selecting at least three kinds of metal or metalloid elements, the at least three kinds of metal or metalloid elements being selected from two or three regions selected from the group consisting of the first region, the second region and the third region, each of the selected two or three regions including at least one of the at least three kinds of metal or metalloid elements;
(C) determining respective contents of the at least three kinds of metal or metalloid elements selected from the regions in the absorber film so as to be obtained a predetermined ratio within the reflectance ratio ($R_A/R_B$) range and a predetermined phase shift within the phase shift range, for a predetermined thickness; and
(D) forming the absorber film composed of a material containing the at least three kinds of metal or metalloid elements selected from the regions that have the determined contents, respectively.

Preferably, the method includes the step of forming a conductive film on the other main surface of the substrate.

Preferably, in the method, the absorber film has phase shift function that shifts a phase of the reflected light from the absorber film in a range of 180 to 240° to a phase of the reflected light from the multilayer reflection film and the protection film.

ADVANTAGEOUS EFFECTS

According to the invention, a reflective mask blank including a thin absorber film in which a reflection ratio and a phase shift required in a reflective mask utilizing phase shift function, which enhances contrast of optical image (projected image) of the pattern, are ensured can be provided. Further, as such a reflective mask blank, a reflective mask blank including an absorber film which is required various reflection ratios and phase shifts can be effectively manufactured.

BRIEF DESCRIPTION OF THE DRAWINGS

FIG. 1A is a cross-sectional view illustrating an example of the reflective mask blank RMB of the invention; and FIG. 1B is a cross-sectional view illustrating an example of the reflective mask RM obtained by patterning the absorber film of the reflective mask blank RMB shown in FIG. 1A.

FIG. 2 is a graph showing simulation results of contrast of a projected image of an absorber pattern.

FIGS. 3A to 3C are graphs showing refractive indexes n and extinction coefficients k calculated from film thicknesses, reflectance ratios, and phase shifts, of the absorber films (absorber patterns) at a thickness of 60 nm in FIG. 3A, at a thickness of 50 nm in FIG. 3B, and at a thickness of 40 nm in FIG. 3C, respectively.

FIGS. 4A and 2B are graphs showing ranges of refractive indexes n and extinction coefficients k that correspond to a predetermined reflectance ratio and a predetermined phase shift when a film thickness of the absorber film (absorber pattern) is in the range of 40 to 65 nm at a phase shift of 180°, 200° and 220° in FIG. 4A, and at a phase shift of 240° and 260° in FIG. 4B, respectively.

FIG. 5 is a diagram showing refractive indexes n and extinction coefficients k of simple substances of metal materials and metalloid materials with respect to EUV light.

FIG. 6 is a flowchart showing an example of steps for forming the absorber film of the invention.

FIG. 7 is a diagram showing a refractive index n and an extinction coefficient k of the material of the absorber film of Example 1 together with a part of the diagram in FIG. 5.

FIG. 8 is a diagram showing refractive indexes n and extinction coefficients k of the materials of the absorber films of Examples 2 and 3 together with a part of the diagram in FIG. 5.

FIG. 9 is a diagram showing a refractive index n and an extinction coefficient k of the material of the absorber film of Example 4 together with a part of the diagram in FIG. 5.

FIG. 10 is a diagram showing a refractive index n and an extinction coefficient k of the material of the absorber film of Example 5 together with a part of the diagram in FIG. 5.

FURTHER EXPLANATIONS: OPTIONS AND PREFERENCES

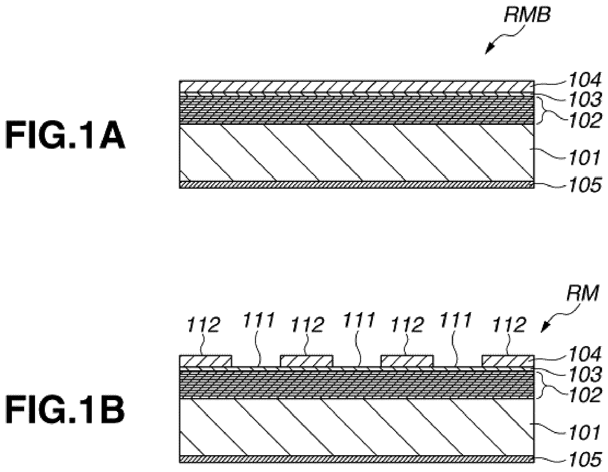

The reflective mask blank (EUV mask blank) and the reflective mask (EUV mask) for EUV exposure of the present invention is described with reference to FIGS. 1A and 1B. FIG. 1A is a cross-sectional view of an example of the reflective mask blank RMB of the invention. In the reflective mask blank RMB, a multilayer reflection film 102 that reflects EUV light, a protection film 103 for the multilayer reflection film, and an absorber film 104 that absorbs a part of incident EUV light and reflects the remainder of the EUV light are formed in this order on one main surface of a substrate 101, preferably a substrate composed of a low thermal expansion material having a surface sufficiently flatten. On the other hand, a conductive film 105, specifically, a conductive film for electrostatically securing a reflective mask to a mask stage of an exposure tool is formed on the other main surface (the opposite side surface or a back surface) of the substrate 101 on which the multilayer reflection film 102, the protection film 103 and the absorber film 104 are formed.

FIG. 1B is a cross-sectional view of an example of the reflective mask RM obtained by patterning the absorber film 104 of the reflective mask blank RMB shown in FIG. 1A. In the patterning of the absorber film 104, a resist film is formed on the absorber film 104, a pattern is drawn by, for example, electron beam lithography, and resist pattern is formed. Then, an absorber pattern can be formed by etching of the absorber film 104 underlying the resist pattern with using the resist pattern as a mask. By this patterning, a portion 111 at which the absorber film has been removed, and the absorber pattern 112 are formed, and a reflective mask RM having a basic structure can be obtained after removing the remaining resist film. The other components in FIG. 1B are designated by the same reference numerals as those in FIG. 1A, and description of them is omitted.

The substrate has a coefficient of thermal expansion preferably within a range of $\pm 1.0 \times 10^{-8}/°C$, more preferably $\pm 5.0 \times 10^{-9}/°C$. Further, it is preferable that the main surface of the substrate on the side where the absorber film is formed is processed so as to have high flatness in the region where the absorber pattern is formed. The surface roughness of the surface is, for example, as a RMS, is preferably not more than 0.1 nm, more preferably not more than 0.06 nm.

The multilayer reflection film is a multilayer film in which layers of a low refractive index material and layers of a high refractive index material are alternately laminated. For example, a Mo/Si periodically laminated film in which molybdenum (Mo) layers and silicon (Si) layers are alternately laminated for about 40 cycles (40 layers, respectively) is used for EUV light having an exposure wavelength of 13 to 14 nm. A film thickness of the multilayer reflection film is normally about 280 to 350 nm.

The protection film is also called a capping layer, and is provided to protect the multilayer reflection film when forming a pattern of absorber film on the protection film or when correcting the pattern of the absorber film. As the material of the protection film, silicon is used, and further ruthenium or a compound of ruthenium added with niobium or zirconium, or other material is used. A film thickness of the protection film is normally about 2.5 to 4 nm. In the reflective mask blank (EUV mask blank) and the reflective mask for EUV exposure (EUV mask), the multilayer reflection film on which the protection film has been formed normally has a reflectance of 65 to 67% with respect to EUV light.

The conductive film is optionally formed to electrostatically secure the reflective mask to a mask stage of an exposure tool. As the material of the conductive film, a material containing chromium or tantalum as a main component is used. A film thickness of the conductive film is normally about 20 to 300 nm.

Next, optical characteristics required for the absorber film of the invention is described. When generating a projected image of a pattern on a semiconductor substrate using a reflective mask having an absorber pattern, the contrast of the projected image of the pattern and the pattern transfer performance such as a depth of focus must be sufficient even in a region where the pattern has a fine size. In this regard, it is necessary to set a film thickness of the absorber film (absorbent pattern), and a reflectance ratio and a phase shift in the pattern portion so that sufficient pattern transfer performance can be obtained. The pattern transfer performance of the reflective mask may be evaluated by actually manufacturing and measuring of a reflective mask, and also can be taken by optical simulation.

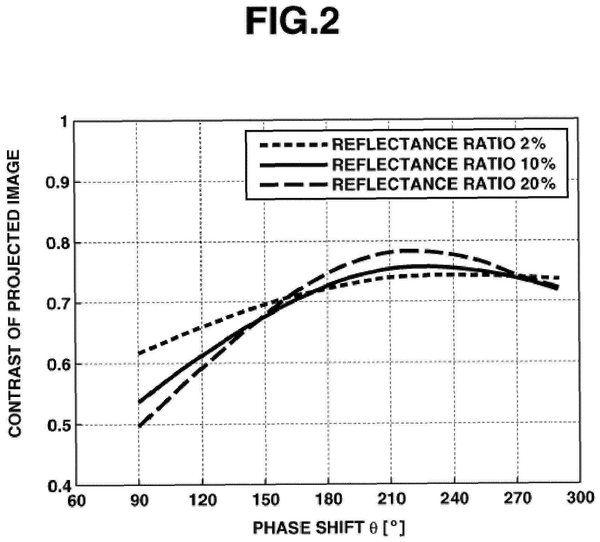

FIG. 2 is a diagram showing simulation results of contrast of a projected image of a pattern obtained when a film thickness of an absorber pattern is set to 60 nm under assumption of transferring a dot array having a width of 17 nm and a pitch of 52 nm onto a semiconductor substrate. The horizontal line represents phase shift between light reflected from the absorber pattern and light reflected from a portion at which the absorber film has been removed. The three curves in FIG. 2 represent the cases in which reflectance ratios are set to 2%, 10% or 20%, respectively. The reflectance ratio of 2% corresponds to a reflectance ratio of a conventional absorber pattern of a Ta-based material having a thickness of 70 nm that is not considered for utilizing phase shift function, that is, that does not have sufficient phase shift function. On the other hand, in the reflectance ratio of 10% or 20%, each of the cases is assumed an absorber film (absorber pattern) that is utilized phase shift function, and it is confirmed that a large phase shift is obtained at a phase shift of not less than 180° in each of the cases. A required phase shift depends on type of pattern, lighting conditions for the pattern, and other parameters. However, not only in the case of this setting, but also in many cases, a phase shift not less than 180° can provide a high contrast, for example, a contrast of not less than 0.7 that is preferable for lithography. Further, the phase shift is preferably not more than 260°, more preferably not more than 240° in consideration for transfer of a hole array or a fine line pattern. According to these results, it is confirmed that required optical constants (refractive index n, extinction coefficient k) for the absorber film (absorbent pattern) that correspond to predetermined values of a film thickness, a reflectance ratio, and a phase shift in the absorber film (absorbent pattern) can be obtained from the values of a film thickness, a reflectance ratio, and a phase shift.

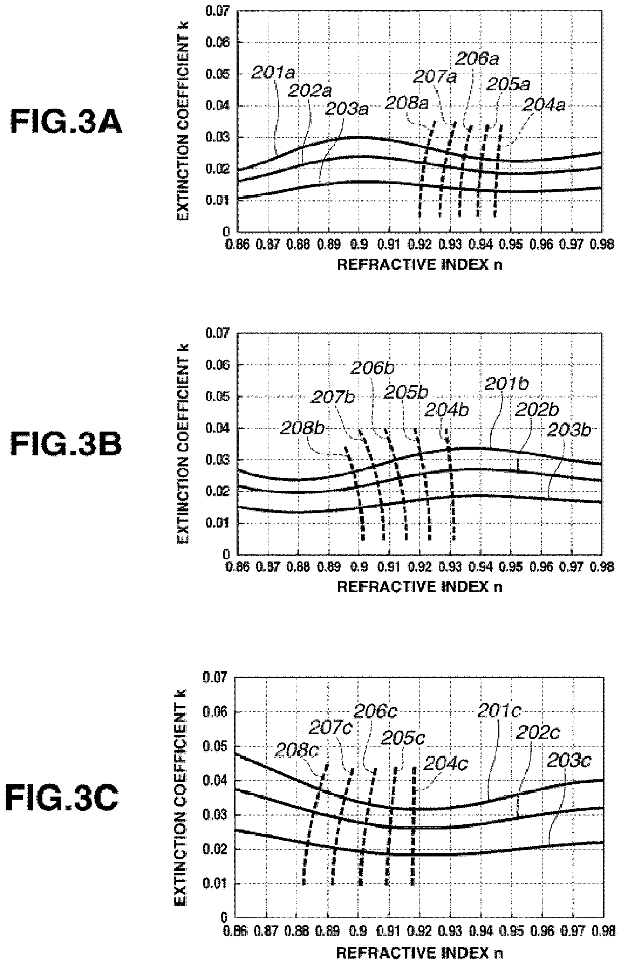

FIGS. 3A to 3C show results of refractive indexes n and extinction coefficients k obtained from film thicknesses, reflectance ratios, and phase shifts of the absorber films (absorber patterns). FIG. 3A shows a case of a thickness of 60 nm. Curve 201a, curve 202a and curve 203a show refractive indexes n and extinction coefficients k when the reflectance ratios are 6%, 10% and 20%, respectively. On the other hand, curve 204a, curve 205a, curve 206a, curve 207a and curve 208a show refractive indexes n and extinction coefficients k when the phase shifts are 180°, 200°, 220°, 240° and 260°, respectively.

FIG. 3B shows a case of a thickness of 50 nm. Curve 201b, curve 202b and curve 203b show refractive indexes n and extinction coefficients k when the reflectance ratios are 6%, 10% and 20%, respectively. On the other hand, curve 204b, curve 205b, curve 206b, curve 207b and curve 208b show refractive indexes n and extinction coefficients k when the phase shifts are 180°, 200°, 220°, 240° and 260°, respectively.

FIG. 3C shows a case of a thickness of 40 nm. Curve 201c, curve 202c and curve 203c show refractive indexes n and extinction coefficients k when the reflectance ratios are 6%, 10% and 20%, respectively. On the other hand, curve 204c, curve 205c, curve 206c, curve 207c and curve 208c show refractive indexes n and extinction coefficients k when the phase shifts are 180°, 200°, 220°, 240° and 260°, respectively.

According to these results, for example, the refractive index n and the extinction coefficient k required for a material of the absorber film (absorbent pattern) having a film thickness of 60 nm, a reflectance ratio of 10%, and a phase shift of 220° are indicated at the intersection of the curve 202a and the curve 206a. It is confirmed that when the film thickness of the absorber film is specified, the optical constants giving a desired reflectance ratio and a phase shift can be obtained.

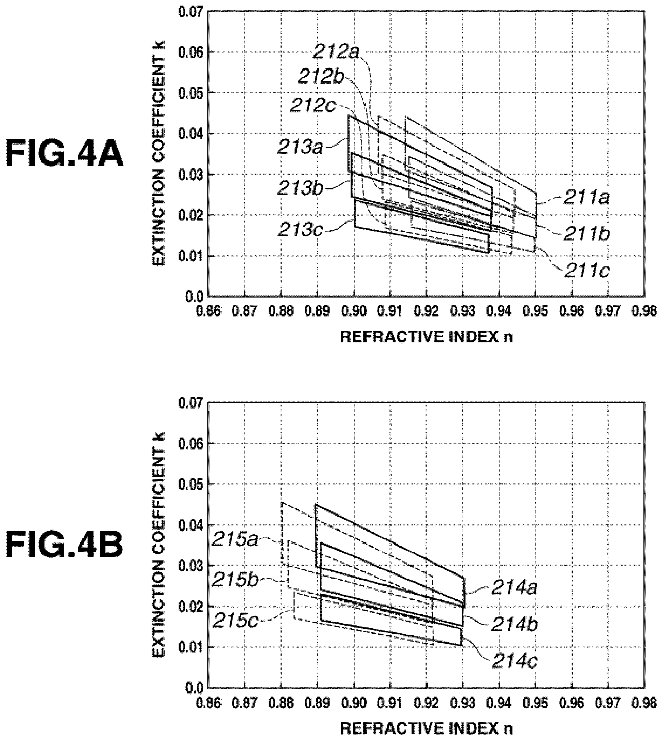

Further, FIGS. 4A and 4B shows results of a ranges of a refractive index n and an extinction coefficient k that correspond to a predetermined reflectance ratio and phase shift when a film thickness of the absorber film (absorbent pattern) is varied from 40 to 65 nm. In FIG. 4A, region 211a, region 211b and region 211c show the refractive indexes n and the extinction coefficients k when reflectance ratios are 6%, 10% and 20%, respectively, at a phase shift of 180°. Region 212a, region 212b and region 212c show the refractive indexes n and the extinction coefficients k when reflectance ratios are 6%, 10% and 20%, respectively, at a phase shift of 200°. Region 213a, region 213b and region 213c show the refractive indexes n and the extinction coefficients k when reflectance ratios are 6%, 10% and 20%, respectively, at a phase shift of 220°. On the other hand, in FIG. 4B, regions 214a, region 214b and region 214c show the refractive indexes n and the extinction coefficients k when reflectance ratios are 6%, 10% and 20%, respectively, at a phase shift of 240°. Regions 215a, region 215b and region 215c show the refractive indexes n and the extinction coefficients k when reflectance ratios are 6%, 10% and 20%, respectively, at a phase shift of 260°. For example, since good contrast is obtained at a reflectance ratio of 20% and a phase shift of 220° in the simulation results of the contrast of the projected image of the pattern shown in FIG. 2, it is confirmed that the refractive index n and the extinction coefficient k with in region 213c in FIG. 4A is preferably adopted.

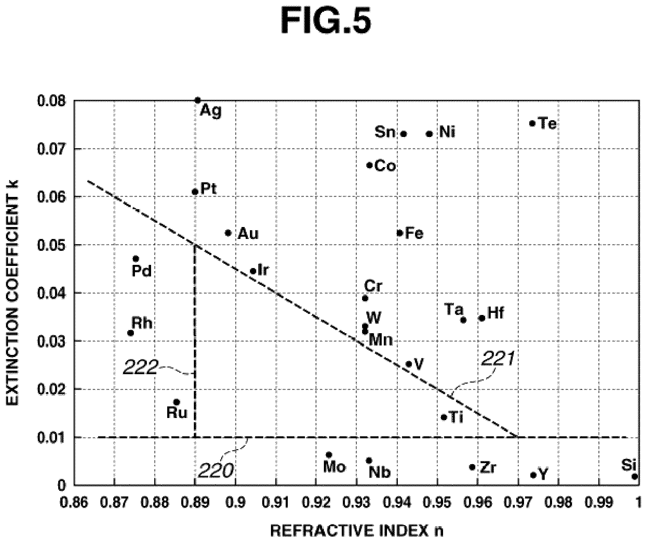

On the other hand, FIG. 5 is a diagram plotting refractive indexes n and extinction coefficients k of simple substance of metal or metalloid elements with respect to EUV light having a wavelength near 13.5 nm. In comparing FIG. 4 with FIG. 5, for example, in the region 213c in FIG. 4A of the reflectance ratio of 20% and the phase shift of 220° in which good contrast is obtained in the simulation results of the contrast of the projected image of the pattern shown in FIG. 2, it is confirmed that no material that is a simple substance of metal or metalloid element having a refractive index n and an extinction coefficient k within the region 213c is existed. Similarly, in the region 213a or region 213b of the reflectance ratio of 6% or 10% and the phase shift of 220°, and in the region 214a, region 214b or region 214c in FIG. 4B of the reflectance ratio of 6%, 10% or 20% and the phase shift of 240°, it is confirmed that no material that is a simple substance of metal or metalloid element having a refractive index n and an extinction coefficient k within the region is existed. In the case that the phase shift is 260°, in the region 215a, region 215b or region 215c of the reflectance ratio of 6%, 10% or 20% and the phase shift of 260°, it is confirmed that no material that is a simple substance of metal or metalloid element having a refractive index n and an extinction coefficient k within the region is existed except for Ru which is hard to use as a material for the absorber film, since it is used as a material for the protection film of the multilayer reflector in some cases.

In the invention, metal and metalloid elements for a material of an absorber film (absorber pattern) is defined and classified to a first elemental group, a second elemental group and a third elemental group by a refractive index n and an extinction coefficient k of each simple substance of the metal and metalloid elements. Three broken lines of line 220, line 221 and line 222 in FIG. 5 shows a line representing k=0.01, a line representing relation of n+2k=0.99, and a line representing n=0.89, respectively. In comparing FIG. 5 with FIG. 4, it is confirmed that a range of refractive index n and extinction coefficient k that correspond to a reflectance ratio of 6 to 20% and a phase shift 180 to 260°, in particular, almost of the area within the fifteen regions (regions 211a to region 215c) in FIGS. 4A and 4B belongs to the inner (excluding on the lines) area surrounded by the three lines of line 220, line 221 and line 222 shown in FIG. 5. Particularly, it is confirmed that a range of refractive index n and extinction coefficient k that corresponds to a reflectance ratio of 6 to 20% and a phase shift 220 to 240°, and is suitable for a reflective mask utilizing phase shift function, in particular, the area within the region 213a, region 213b, region 213c, region 214a, region 214b and region 214c in FIGS. 4A and 4B belongs to the inner (excluding on the lines) area surrounded by the three lines of line 220, line 221 and line 222 shown in FIG. 5.

Accordingly, in the invention, with respect to a refractive index n and an extinction coefficient k of a simple substance of a metal or metalloid element, the elements are defined to anyone of:

(i) a first element of a metal or metalloid element included in a range of a first region represented by the following expression (1):

$$k \leq 0.01 \qquad (1),$$

or, the first element that is included in a first elemental group satisfying the expression (1);
(ii) a second element of a metal or metalloid element included in a range of a second region that is not included in the first region, and is represented by the following expression (2):

$$n + 2k \geq 0.99 \qquad (2),$$

or, the second element that is not included in the first elemental group, and is included in a second elemental group satisfying the expression (2); and
(iii) a third element of a metal or metalloid element included in a range of a third region that is not included in both of the first region and the second region, and is represented by the following expression (3):

$$n \leq 0.89 \qquad (3),$$

or, the third element that is not included in both of the first elemental group and the second elemental group, and is included in a third elemental group satisfying the expression (3).

At least three kinds, preferably three kinds, of the elements are selected from two or three regions, preferably three regions, selected from the group consisting of the first region, the second region and the third region, and each of the selected two or three regions includes at least one of the elements. In other words, the absorber film is composed of a material that contains at least three kinds, preferably three kinds, of elements are selected from two or three elemental groups, preferably three elemental groups, selected from the group consisting of the first elemental group, the second elemental group and the third elemental group, and each of the selected two or three elemental groups includes at least one of the elements. Examples of materials containing the at least three kinds, preferably three kinds, of elements include alloys consisting of metals and metalloids, and compounds of metals, metalloids, or metal(s) and/or metalloid(s) and light element(s) selected from the group consisting of nitrogen, oxygen, carbon and hydrogen. On the other hand, if two or three of the elements are selected from only anyone of the region or elemental group, a material having a refractive index n and an extinction coefficient k that correspond to a reflectance ratio of 6 to 20% and a phase shift of 220 to 240° cannot be obtained.

Examples of the metal or metalloid elements included in the first elemental group include Mo, Nb, Zr, Si, Y, Be, Ba, Ce, La, K and Ca. Among them, Mo, Nb, Zr, Si and Y are preferable, and Mo is more preferable. Examples of the metal or metalloid elements included in the second elemental group include W, Au, Ir, V, Pt, Cr, Ta, Hf, Co, Ni, Sn, Te, Fe, Cu, Bi, Ag, In, Zn, Sb, Re, Os, Pb and Mn. Among them, W, Au, Ir, V, Pt, Cr, Ta, Hf, Co, Ni, Sn and Te are preferable, and W is more preferable. Examples of the metal or metalloid elements included in the third elemental group include Ru, Rh and Pd. Among them, Ru is preferable.

The absorber film may be a single layer or a multilayer. It is preferable that a thickness of the absorber film is thin. A thick absorber film is disadvantageous in not only pattern formation, but also deterioration of pattern resolution due to shadowing effect during exposure. Therefore, a thickness of the absorber film is preferably not more than 65 nm, more preferably not more than 60 nm. On the other hand, a lower limit of the thickness may be not less than 20 nm, and is preferably not less than 30 nm. Although depending on a required reflectance ratio and a required phase shift, in some cases, it is preferable in a case that the thickness of the absorber film of not more than 50 nm, or the thickness of the absorber film of not less than 40 nm.

Content of the element selected from each of the elemental group may be determined so that, with respect to EUV light, a reflectance ratio ($R_A/R_B$) that is a ratio of a reflectance $R_A$ (%) of the absorber film to a reflectance $R_B$ (%) of the multilayer reflection film and the protection film is in a range of preferably not less than 0.05 (not less than 5%, expressed in percentage), more preferably not less than 0.06 (not less than 6%, expressed in percentage), even more preferably not less than 0.08 (not less than 8%, expressed in percentage), and preferably not more than 0.25 (not more than 25%, expressed in percentage), more preferably not more than 0.2 (not more than 20%, expressed in percentage), even more preferably not more than 0.15 (not more than 15%, expressed in percentage). In addition, content of the element selected from each of the elemental group may be determined so that the absorber film shifts a phase of the reflected light from the absorber film in a range of preferably not less than 180°, more preferably not less than 190°, even more preferably not less than 200°, further preferably not less than 210°, most preferably not less than 220°, and preferably not more than 260°, more preferably not more than 240°, to a phase of the reflected light from the multilayer reflection film and the protection film. The absorber film can be formed with a material in which each of the element selected from each of the elemental groups has a predetermined content. In the absorber film, each content of the element selected from each of the elemental groups is preferably not less than 5 at%.

In particular, the contents of the elements selected from the elemental groups can be determined in a range inside of a triangle configured by connecting plots of the elements selected from the elemental groups with lines, and in a range of refractive index n and extinction coefficients k that correspond to a reflectance ratio of preferably not less than 5%, more preferably not less than 6%, even more preferably not less than 8%, and preferably not more than 25%, more preferably not more than 25%, even more preferably not more than 15%, and a phase shift of preferably not less than 180°, more preferably not less than 190°, even more preferably not less than 200°, further preferably not less than 210°, most preferably not less than 220°, and preferably not more than 260°, more preferably not more than 240°. For example, the contents of the elements selected from the elemental groups can be determined in the range of the range 213a, range 213b, range 213c, range 214a, range 214b and range 214c in FIGS. 4A and 4B so that the absorber film (absorber pattern) has a required refractive index n and a required extinction coefficients k.

A material having a refractive index n and an extinction coefficients k that correspond to the reflectance ratio and the phase shift included in the ranges is preferably in the range in FIG. 5 satisfying all of the following expressions:

$$k > 0.01,$$

$$n + 2k < 0.99,$$

and

$$n > 0.89,$$

for example, in anyone of the fifteen regions (regions 211a to region 215c) in FIGS. 4A and 4B, particularly, in anyone of the region 213a, region 213b, region 213c, region 214a, region 214b and region 214c. Since the required refractive index n and extinction coefficient k depend on shape and density of a pattern to be transferred and lighting conditions for the pattern, elements to be selected and contents thereof may be determined in consideration of these. The contents may also be determined by simulation. With consideration for the fifteen regions (regions 211a to 215c) shown in FIGS. 4A and 4B, the refractive index n is preferably not more than 0.95, more preferably not more than 0.94, even more preferably not more than 0.93.

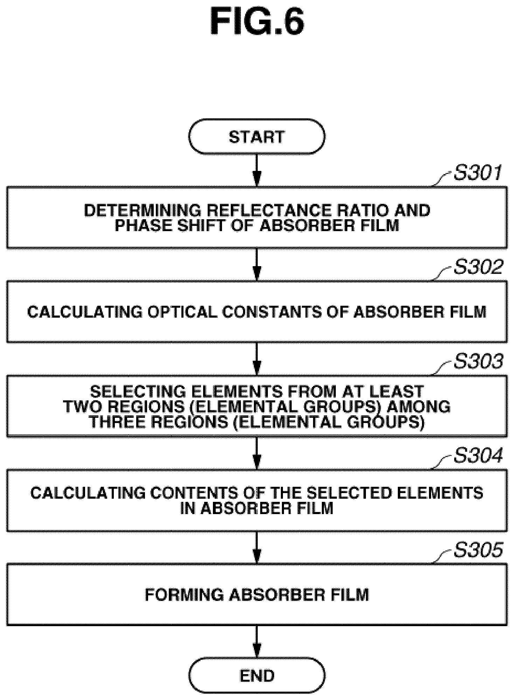

FIG. 6 is a flowchart showing an example of steps of forming the absorber film of the reflective mask blank of the invention. First, the reflectance ratio and the phase shift required for the absorber film (absorber pattern) to be formed are determined by optical simulation (step S301). Next, optical constants (a refractive index n and an extinction coefficient k) of the absorber film (absorbent pattern) are calculated in accordance with a film thickness (step S302). Next, at least three kinds of elements, preferably three kinds of elements are selected by the above-mentioned method, from two or three regions (elemental groups) selected from the group consisting of the first region (first elemental group, the second region (second elemental group), and the third region (third elemental group) (step S303). Next, contents of the selected elements are calculated so that the required optical constants can be obtained (step S304). The contents can be calculated from the optical constants of simple substances of the selected elements, and the results of the optical constants obtained in step S302. Then, an absorber film is formed so that the selected elements are contained at the calculated contents (step S305).

As a method for forming the absorber film, a sputtering method using a target containing the selected element and a sputtering gas is preferable. As the sputtering, magnetron sputtering is preferable. Specifically, as the sputtering gas, a rare gas such as Ar gas and Kr gas may be used. In addition, the absorber film may be formed by reactive sputtering in which a target is sputtered with using a reactive gas such as nitrogen gas ($N_2$), oxygen gas ($O_2$), nitrogen oxide gases ($N_2O$, NO, $NO_2$), carbon oxide gases (CO, $CO_2$), hydrocarbon gases ($CH_4$ and the like), and other gases, along with the rare gas. A pressure (spattering pressure) in a sputtering chamber is preferably not less than 0.1 Pa, and preferably less than 1 Pa, more preferably not more than 0.5 Pa.

In manufacturing the reflective mask blank, before the formation of the absorber film, a multilayer reflection film and a protection film thereof are also formed, and may be formed by a known method. Further, in the manufacturing of the reflective mask blank, a conductive film may be formed. This film may also be formed by a known method.

The conductive film may be initially formed on the substrate, or may be formed after anyone or all of the multilayer reflection film, the protection film and the absorber film are formed.

EXAMPLES

Examples of the invention are given below by way of illustration and not by way of limitation.

Example 1

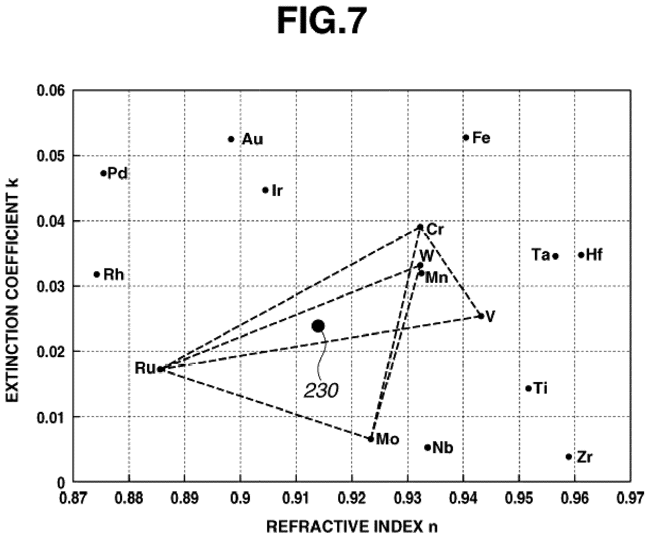

The intended reflective mask in this example is a reflective mask including an absorber pattern having a thickness of 50 nm with a reflectance ratio of 10% and a phase shift of 220°. A refractive index n and an extinction coefficient k of a material of an absorber film for forming this absorber pattern were calculated by optical simulation. The calculated refractive index n and extinction coefficient k were n=0.914 and k=0.024, respectively. FIG. 7 shows a refractive index n and an extinction coefficient k of the material of the absorber film together with a part of the diagram in FIG. 5. Plot 230 represents these calculated refractive index n and extinction coefficient k.

Next, molybdenum (Mo) was selected from the first region (first elemental group), chromium (Cr), tungsten (W) and vanadium (V) were selected from the second region (second elemental group), and ruthenium (Ru) was selected from the third region (third elemental group). In each case, the refractive index n=0.914 and extinction coefficient k=0.024 represented by plot 230 is inside of the triangle configured by connecting plots of elements selected from each of the elemental groups with lines. Contents of the first element, second element and third element were determined to satisfy the calculated refractive index n and extinction coefficient k.

In the case of a MoCrRu film in which molybdenum (Mo), chromium (Cr) and ruthenium (Ru) were selected as the first element, second element and third element, respectively, it was confirmed that the calculated refractive index n and extinction coefficient k can be obtained at Mo content of 20 at %, Cr content of 46 at%, and Ru content of 34 at %. In the case of a MoWRu film in which molybdenum (Mo), tungsten (W) and ruthenium (Ru) were selected as the first element, second element and third element, respectively, it was confirmed that the calculated refractive index n and extinction coefficient k can be obtained at Mo content of 12 at %, W content of 48 at%, and Ru content of 40 at %. In the case of a CrVRu film in which chromium (Cr) and vanadium (V), and ruthenium (Ru) were selected as the second elements and third element, respectively, it was confirmed that the calculated refractive index n and extinction coefficient k can be obtained at Cr content of 20 at %, V content of 34 at%, and Ru content of 46 at %.

Next, a reflective mask blank was manufactured with using a material for the absorber film having the determined contents. First, a multilayer reflection film that reflects EUV light and a protection film thereof were formed in this order on one main surface of a substrate composed of a low thermal expansion material. A Mo/Si multilayer reflection film (40 pairs) was formed at a period length of 7.02 nm for which a thickness of 4.21 nm for the Si layer and a thickness of 2.81 nm for the Mo layer were set. As the protection film, a Ru film having a thickness of 3.5 nm was formed. The reflectance of the multilayer reflection film on which the protection film was formed was about 66% with respect to EUV light.

Next, an absorber film having a thickness of 50 nm was formed on the protection film. Among the three kinds of absorber films, the MoCrRu containing Mo at 20 at%, Cr at 46 at%, and Ru at 34 at% was formed by a DC magnetron sputtering method with using three targets of molybdenum, chromium and ruthenium, and Ar gas as a sputtering gas. A reflective mask blank was obtained after forming a conductive film on the other main surface of the substrate.

A reflectance of the absorber film in the obtained reflective mask blank was measured with respect to EUV light. It was confirmed that the reflectance is approximately 6.6% that corresponds to the intended reflectance ratio ($R_A/R_B$) of 0.1 (10%). Further, it was confirmed that a phase shift with respect to EUV light between the multilayer reflection film with the protection film formed thereon, and the absorber film is 220° that corresponds to the intended value.

Example 2

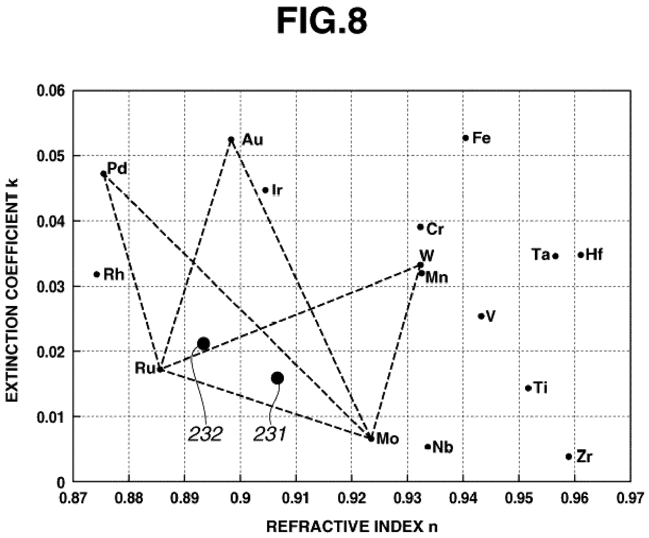

The intended reflective mask in this example is a reflective mask including an absorber pattern having a thickness of 50 nm with a reflectance ratio of 20% and a phase shift of 240°. In this case, a rough pattern having a fine pattern size for transfer by the reflective mask but a pitch size of about three times of the pattern size was assumed. A refractive index n and an extinction coefficient k of a material of an absorber film for forming this absorber pattern were calculated by optical simulation. The calculated refractive index n and extinction coefficient k were n=0.907 and k=0.016, respectively. FIG. 8 shows a refractive index n and an extinction coefficient k of the material of the absorber film together with a part of the diagram in FIG. 5. Plot 231 represents these calculated refractive index n and extinction coefficient k.

Next, molybdenum (Mo) was selected from the first region (first elemental group), tungsten (W) was selected from the second region (second elemental group), and ruthenium (Ru) and palladium (Pd) were selected from the third region (third elemental group). In each case, the refractive index n=0.907 and extinction coefficient k=0.016 represented by plot 231 is inside of the triangle configured by connecting plots of elements selected from each of the elemental groups with lines. Contents of the first element, second element and third element were determined to satisfy the calculated refractive index n and extinction coefficient k.

In the case of a MoWRu film in which molybdenum (Mo), tungsten (W) and ruthenium (Ru) were selected as the first element, second element and third element, respectively, it was confirmed that the calculated refractive index n and extinction coefficient k can be obtained at Mo content of 34 at %, W content of 15 at%, and Ru content of 51 at %. In the case of a MoRuPd film in which molybdenum (Mo), and ruthenium (Ru) and palladium (Pd) were selected as the first element and third elements, respectively, it was confirmed that the calculated refractive index n and extinction coefficient k can be obtained at Mo content of 59 at %, Ru content of 23 at%, and Pd content of 18 at %.

Next, a reflective mask blank was manufactured with using a material for the absorber film having the determined contents. First, a multilayer reflection film that reflects EUV light and a protection film thereof were formed in this order on one main surface of a substrate composed of a low thermal expansion material. A Mo/Si multilayer reflection film (40 pairs) was formed at a period length of 7.02 nm for which a thickness of 4.21 nm for the Si layer and a thickness of 2.81 nm for the Mo layer were set. As the protection film, a Ru film having a thickness of 3.5 nm was formed. The reflectance of the multilayer reflection film on which the protection film was formed was about 66% with respect to EUV light.

Next, an absorber film having a thickness of 40 nm was formed on the protection film. Among the two kinds of absorber films, the MoWRu containing Mo at 34 at%, W at 15 at%, and Ru at 51 at% was formed by a DC magnetron sputtering method with using three targets of molybdenum, tungsten and ruthenium, and Ar gas as a sputtering gas. A reflective mask blank was obtained after forming a conductive film on the other main surface of the substrate.

A reflectance of the absorber film in the obtained reflective mask blank was measured with respect to EUV light. It was confirmed that the reflectance is approximately 13.3% that corresponds to the intended reflectance ratio ($R_A/R_B$) of 0.2 (20%). Further, it was confirmed that a phase shift with respect to EUV light between the multilayer reflection film with the protection film formed thereon, and the absorber film is 240° that corresponds to the intended value.

Example 3

The intended reflective mask in this example is a reflective mask including an absorber pattern having a thickness of 40 nm with a reflectance ratio of 20% and a phase shift of 240°. In this case, a rough pattern having a fine pattern size for transfer by the reflective mask but a pitch size of about three times of the pattern size was assumed. A refractive index n and an extinction coefficient k of a material of an absorber film for forming this absorber pattern were calculated by optical simulation. The calculated refractive index n and extinction coefficient k were n=0.893 and k=0.021, respectively. FIG. 8 shows a refractive index n and an extinction coefficient k of the material of the absorber film together with a part of the diagram in FIG. 5. Plot 232 represents these calculated refractive index n and extinction coefficient k.

Next, molybdenum (Mo) was selected from the first region (first elemental group), gold (Au) was selected from the second region (second elemental group), and ruthenium (Ru) and palladium (Pd) were selected from the third region (third elemental group). In each case, the refractive index n=0.893 and extinction coefficient k=0.021 represented by plot 232 is inside of the triangle configured by connecting plots of elements selected from each of the elemental groups with lines. Contents of the first element, second element and third element were determined to satisfy the calculated refractive index n and extinction coefficient k.

In the case of a MoAuRu film in which molybdenum (Mo), gold (Au) and ruthenium (Ru) were selected as the first element, second element and third element, respectively, it was confirmed that the calculated refractive index n and extinction coefficient k can be obtained at Mo content of 13 at %, Au content of 12 at%, and Ru content of 75 at %. In the case of a MoRuPd film in which molybdenum (Mo), and ruthenium (Ru) and palladium (Pd) were selected as the first element and third elements, respectively, it was confirmed that the calculated refractive index n and extinction coefficient k can be obtained at Mo content of 23 at %, Ru content of 56 at%, and Pd content of 21 at %.

Next, a reflective mask blank was manufactured with using a material for the absorber film having the determined contents. First, a multilayer reflection film that reflects EUV light and a protection film thereof were formed in this order on one main surface of a substrate composed of a low thermal expansion material. A Mo/Si multilayer reflection film (40 pairs) was formed at a period length of 7.02 nm for which a thickness of 4.21 nm for the Si layer and a thickness of 2.81 nm for the Mo layer were set. As the protection film, a Ru film having a thickness of 3.5 nm was formed. The reflectance of the multilayer reflection film on which the protection film was formed was about 66% with respect to EUV light.

Next, an absorber film having a thickness of 40 nm was formed on the protection film. Among the two kinds of absorber films, the MoAuRu containing Mo at 13 at%, Au at 12 at%, and Ru at 75 at% was formed by a DC magnetron sputtering method with using three targets of molybdenum, gold and ruthenium, and Ar gas as a sputtering gas. A reflective mask blank was obtained after forming a conductive film on the other main surface of the substrate.

A reflectance of the absorber film in the obtained reflective mask blank was measured with respect to EUV light. It was confirmed that the reflectance is approximately 13.3% that corresponds to the intended reflectance ratio ($R_A/R_B$) of 0.2 (20%). Further, it was confirmed that a phase shift with respect to EUV light between the multilayer reflection film with the protection film formed thereon, and the absorber film is 240° that corresponds to the intended value.

Example 4

The intended reflective mask in this example is a reflective mask including an absorber pattern having a thickness of 50 nm with a reflectance ratio of 20% and a phase shift of 260°. In this case, a fine and dense line pattern for transfer by the reflective mask was assumed.

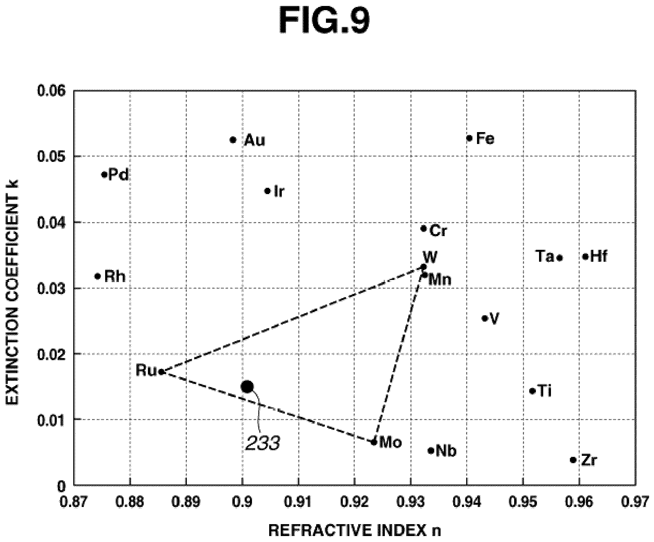

A refractive index n and an extinction coefficient k of a material of an absorber film for forming this absorber pattern were calculated by optical simulation. The calculated refractive index n and extinction coefficient k were n=0.901 and k=0.015, respectively. FIG. 9 shows a refractive index n and an extinction coefficient k of the material of the absorber film together with a part of the diagram in FIG. 5. Plot 233 represents these calculated refractive index n and extinction coefficient k.

Next, molybdenum (Mo) was selected from the first region (first elemental group), tungsten (W) was selected from the second region (second elemental group), and ruthenium (Ru) was selected from the third region (third elemental group). The refractive index n=0.901 and extinction coefficient k=0.015 represented by plot 233 is inside of the triangle configured by connecting plots of elements selected from each of the elemental groups with lines. Contents of the first element, second element and third element were determined to satisfy the calculated refractive index n and extinction coefficient k.

In the case of a MoWRu film in which molybdenum (Mo), tungsten (W) and ruthenium (Ru) were selected as the first element, second element and third element, respectively, it was confirmed that the calculated refractive index n and extinction coefficient k can be obtained at Mo content of 29 at %, W content of 6 at%, and Ru content of 65 at %.

Next, a reflective mask blank was manufactured with using a material for the absorber film having the determined contents. First, a multilayer reflection film that reflects EUV light and a protection film thereof were formed in this order on one main surface of a substrate composed of a low thermal expansion material. A Mo/Si multilayer reflection film (40 pairs) was formed at a period length of 7.02 nm for which a thickness of 4.21 nm for the Si layer and a thickness of 2.81 nm for the Mo layer were set. As the protection film, a Ru film having a thickness of 3.5 nm was formed. The reflectance of the multilayer reflection film on which the protection film was formed was about 66% with respect to EUV light.

Next, an absorber film having a thickness of 50 nm was formed on the protection film. As the absorber film, the MoWRu containing Mo at 29 at%, W at 6 at%, and Ru at 65 at% was formed by a DC magnetron sputtering method with using three targets of molybdenum, tungsten and ruthenium, and Ar gas as a sputtering gas. A reflective mask blank was obtained after forming a conductive film on the other main surface of the substrate.

A reflectance of the absorber film in the obtained reflective mask blank was measured with respect to EUV light. It was confirmed that the reflectance is approximately 13.4% that corresponds to the intended reflectance ratio ($R_A/R_B$) of 0.2 (20%). Further, it was confirmed that a phase shift with respect to EUV light between the multilayer reflection film with the protection film formed thereon, and the absorber film is 260° that corresponds to the intended value.

Example 5

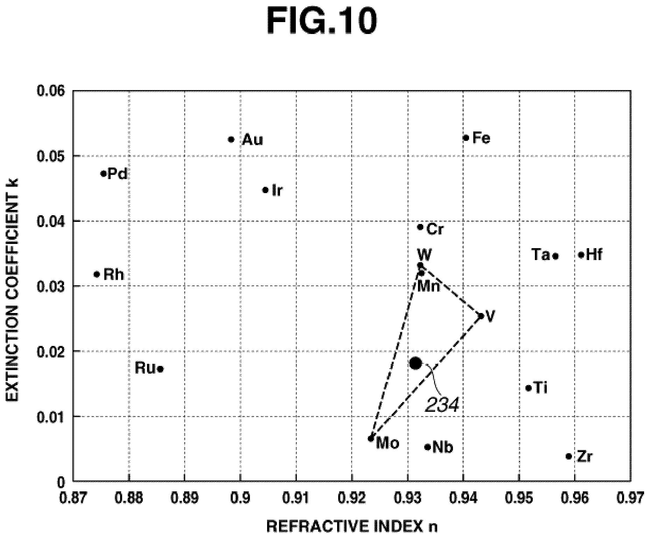

The intended reflective mask in this example is a reflective mask including an absorber pattern having a thickness of 50 nm with a reflectance ratio of 20% and a phase shift of 180° In this case, although contrast in pattern transfer is slightly inferior, intensity level of transfer image s is high, and it is advantageous in throughput of exposure. A refractive index n and an extinction coefficient k of a material of an absorber film for forming this absorber pattern were calculated by optical simulation. The calculated refractive index n and extinction coefficient k were n=0.931 and k=0.018, respectively. FIG. 10 shows a refractive index n and an extinction coefficient k of the material of the absorber film together with a part of the diagram in FIG. 5. Plot 234 represents these calculated refractive index n and extinction coefficient k.

Next, molybdenum (Mo) was selected from the first region (first elemental group), tungsten (W) and vanadium (V) were selected from the second region (second elemental group), as a total of three elements. No element was selected from the third region (third elemental group). The refractive index n=0.931 and extinction coefficient k=0.018 represented by plot 234 is inside of the triangle configured by connecting plots of elements selected from each of the elemental groups with lines. Contents of the first element and second elements were determined to satisfy the calculated refractive index n and extinction coefficient k.

In the case of a MoWV film in which molybdenum (Mo), tungsten (W) and vanadium (V) were selected as the first element and the second elements, respectively, it was confirmed that the calculated refractive index n and extinction coefficient k can be obtained at Mo content of 46 at %, W content of 25 at%, and V content of 29 at %.

Next, a reflective mask blank was manufactured with using a material for the absorber film having the determined contents. First, a multilayer reflection film that reflects EUV light and a protection film thereof were formed in this order on one main surface of a substrate composed of a low thermal expansion material. A Mo/Si multilayer reflection film (40 pairs) was formed at a period length of 7.02 nm for which a thickness of 4.21 nm for the Si layer and a thickness of 2.81 nm for the Mo layer were set. As the protection film, a Ru film having a thickness of 3.5 nm was formed. The reflectance of the multilayer reflection film on which the protection film was formed was about 66% with respect to EUV light.

Next, an absorber film having a thickness of 50 nm was formed on the protection film. As the absorber film, the MoWV containing Mo at 46 at%, W at 25 at%, and V at 29 at% was formed by a DC magnetron sputtering method with using three targets of molybdenum, tungsten and vanadium, and Ar gas as a sputtering gas. A reflective mask blank was obtained after forming a conductive film on the other main surface of the substrate.

A reflectance of the absorber film in the obtained reflective mask blank was measured with respect to EUV light. It was confirmed that the reflectance is approximately 13.4% that corresponds to the intended reflectance ratio ($R_A/R_B$) of 0.2 (20%). Further, it was confirmed that a phase shift with respect to EUV light between the multilayer reflection film with the protection film formed thereon, and the absorber film is 180° that corresponds to the intended value.

**Claims**

1. A reflective mask blank in which a multilayer reflection film that reflects EUV light, a protection film, and an absorber film that absorbs a part of incident EUV light and reflects the remainder of the EUV light are formed in this order on one main surface of a substrate, wherein

with respect to EUV light, a reflectance ratio ($R_A/R_B$) that is a ratio of a reflectance $R_A$ (%) of the absorber film to a reflectance $R_B$ (%) of the multilayer reflection film and the protection film is 0.05 to 0.25,

the absorber film has phase shift function that shifts a phase of the reflected light from the absorber film in a range of 180 to 260° to a phase of the reflected light from the multilayer reflection film and the protection film,

the absorber film is composed of a material containing at least three kinds of metal or metalloid elements, said at least three kinds of metal or metalloid elements are selected from two or three elemental groups selected from the group consisting of a first elemental group, a second elemental group and a third elemental group, each of the selected two or three elemental groups comprises at least one of said at least three kinds of metal or metalloid elements,

each of the metal and metalloid elements included in each of the first, second and third elemental groups has a refractive index n and an extinction coefficient k of a simple substance of metal or metalloid,

each of the metal or metalloid elements included in the first elemental group satisfies the following expression (1):

$$k \leq 0.01 \qquad (1),$$

each of the metal or metalloid elements included in the second elemental group is a metal or metalloid element not included in the first elemental group, and satisfies the following expression (2):

$$n + 2k \geq 0.99 \qquad (2), \text{ and}$$

each of the metal or metalloid elements included in the third elemental group is a metal or metalloid element not included in both of the first and second elemental groups, and satisfies the following expression (3):

$$n \leq 0.89 \qquad (3).$$

2. The reflective mask blank of claim 1 wherein

   the metal or metalloid elements included in the first elemental group are Mo, Nb, Zr, Si and Y, the metal or metalloid elements included in the second elemental group are W, Au, Ir, V, Pt, Cr, Ta, Hf, Co, Ni, Sn and Te, and the metal or metalloid elements included in the third elemental group are Ru, Rh, and Pd.

3. The reflective mask blank of claim 1 wherein

   the metal or metalloid elements included in the first elemental group are Mo, the metal or metalloid elements included in the second elemental group are W, and the metal or metalloid elements included in the third elemental group are Ru.

4. The reflective mask blank of any one of claims 1 to 3 wherein each content of said three kinds of elements selected from the elemental groups is not less than 5 at%.

5. The reflective mask blank of any one of claims 1 to 4 wherein a conductive film is formed on the other main surface of the substrate.

6. The reflective mask blank of any one of claims 1 to 5 wherein the absorber film has phase shift function that shifts a phase of the reflected light from the absorber film in a range of 180 to 240° to a phase of the reflected light from the multilayer reflection film and the protection film.

7. A method for manufacturing a reflective mask blank in which a multilayer reflection film that reflects EUV light, a protection film, and an absorber film that absorbs a part of incident EUV light and reflects the remainder of the EUV light are formed in this order on one main surface of a substrate, wherein

   with respect to EUV light, a reflectance ratio ($R_A/R_B$) that is a ratio of a reflectance $R_A$ (%) of the absorber film to a reflectance $R_B$ (%) of the multilayer reflection film and the protection film is 0.05 to 0.25, the absorber film has phase shift function that shifts a phase of the reflected light from the absorber film in a range of 180 to 260° to a phase of the reflected light from the multilayer reflection film and the protection film, and the absorber film comprises metal or metalloid elements, wherein the method comprises steps of:

   (A) classifying each of the metal or metalloid elements to anyone of a first element included in a first region, a second element included in a second region, and a third element included in a third region,

   each of the metal and metalloid elements having a refractive index n and an extinction coefficient k of a simple substance of metal or metalloid, the first element included in the first region satisfying the following expression (1):

$$k \leq 0.01 \qquad (1),$$

   the second element included in the second region being a metal or metalloid element not included in the first region, and satisfying the following expression (2):

$$n + 2k \geq 0.99 \qquad (2),$$

   and the third element included in the third region being a metal or metalloid element not included in both of the first and second regions, and satisfying the following expression (3):

$$n \leq 0.89 \qquad (3);$$

   (B) selecting at least three kinds of metal or metalloid elements, said at least three kinds of metal or metalloid elements being selected from two or three regions selected from the group consisting of the first region, the second region and the third region, each of the selected two or three regions comprising at least one of said at least three kinds of metal or metalloid elements;
   (C) determining respective contents of said at least three kinds of metal or metalloid elements selected from the regions in the absorber film so as to be obtained a predetermined ratio within the reflectance ratio ($R_A/R_B$) range and a predetermined phase shift within the phase shift range, for a predetermined thickness; and
(D) forming the absorber film composed of a material comprising said at least three kinds of metal or metalloid elements selected from the regions that have the determined contents, respectively.

8. The method of claim 7 comprising the step of forming a conductive film on the other main surface of the substrate.

9. The method of claim 7 or 8 wherein the absorber film has phase shift function that shifts a phase of the reflected light from the absorber film in a range of 180 to 240° to a phase of the reflected light from the multilayer reflection film and the protection film.

FIG.1A

RMB

104
103
102
101
105

FIG.1B

112   111   112   111   112   111   112

RM

104
103
102
101
105

# FIG.2

FIG.3A

FIG.3B

FIG.3C

17

# FIG.4A

# FIG.4B

# FIG.5

# FIG.6

START

S301

DETERMINING REFLECTANCE RATIO AND
PHASE SHIFT OF ABSORBER FILM

S302

CALCULATING OPTICAL CONSTANTS OF ABSORBER FILM

S303

SELECTING ELEMENTS FROM AT LEAST
TWO REGIONS (ELEMENTAL GROUPS) AMONG
THREE REGIONS (ELEMENTAL GROUPS)

S304

CALCULATING CONTENTS OF THE SELECTED ELEMENTS
IN ABSORBER FILM

S305

FORMING ABSORBER FILM

END

# FIG.7

# FIG.8

# FIG.9

# FIG.10

Europäisches
Patentamt

European
Patent Office

Office européen
des brevets

# EUROPEAN SEARCH REPORT

Application Number

**EP 22 15 9540**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2019 049720 A (HOYA CORP) 28 March 2019 (2019-03-28) | 1,2,4-9 | INV. G03F1/24 |
| Y | * paragraph [0039] – paragraph [0086] * * figures 1,2 * | 3 | G03F1/26 G03F1/54 G03F1/58 |
| Y | WO 2020/137928 A1 (HOYA CORP [JP]) 2 July 2020 (2020-07-02) | 3 | |
| A | * paragraphs [0076], [0085] * | 1,7 | |
| A | US 2019/384158 A1 (IKEBE YOHEI [JP] ET AL) 19 December 2019 (2019-12-19) * the whole document * | 1,7 | |

TECHNICAL FIELDS
SEARCHED      (IPC)

G03F

The present search report has been drawn up for all claims

| Place of search | Date of completion of the search | Examiner |
|---|---|---|
| Munich | 21 July 2022 | Meixner, Matthias |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 22 15 9540

This annex lists the patent family members relating to the patent documents cited in the above-mentioned European search report.
The members are as contained in the European Patent Office EDP file on
The European Patent Office is in no way liable for these particulars which are merely given for the purpose of information.

21-07-2022

| Patent document cited in search report | | Publication date | Patent family member(s) | | Publication date |
|---|---|---|---|---|---|
| JP 2019049720 | A | 28-03-2019 | JP 6408790 | B2 | 17-10-2018 |
| | | | JP 6661724 | B2 | 11-03-2020 |
| | | | JP 2015008283 | A | 15-01-2015 |
| | | | JP 2019049720 | A | 28-03-2019 |
| WO 2020137928 | A1 | 02-07-2020 | JP 2020106639 | A | 09-07-2020 |
| | | | KR 20210102199 | A | 19-08-2021 |
| | | | SG 11202106508P | A | 29-07-2021 |
| | | | TW 202041964 | A | 16-11-2020 |
| | | | US 2022107557 | A1 | 07-04-2022 |
| | | | WO 2020137928 | A1 | 02-07-2020 |
| US 2019384158 | A1 | 19-12-2019 | JP 6861095 | B2 | 21-04-2021 |
| | | | JP 2018146945 | A | 20-09-2018 |
| | | | JP 2021101258 | A | 08-07-2021 |
| | | | KR 20190117755 | A | 16-10-2019 |
| | | | SG 11201907623R | A | 27-09-2019 |
| | | | TW 201842396 | A | 01-12-2018 |
| | | | US 2019384158 | A1 | 19-12-2019 |
| | | | US 2021255536 | A1 | 19-08-2021 |

EPO FORM P0459

For more details about this annex : see Official Journal of the European Patent Office, No. 12/82

**EP 4 053 632 A1**

## REFERENCES CITED IN THE DESCRIPTION

**Patent documents cited in the description**

- JP 2006228766 A

- JP 2011029334 A